# DEMANDE DE BREVET EUROPEEN

(11) **EP 0 780 694 A1**
(43) Date de publication de la demande: **25.06.1997**
(21) Numéro de dépôt: 96410123.2
(22) Date de dépôt: 17.12.1996
(51) Int. Cl.: G01R 31/265, H01L 21/66, G01N 21/71

(54) **Réalisation d'un échantillon de référence pour appareil de caractérisation de doses implantées**

(30) Priorité: 20.12.1995 FR 9515510
(71) Demandeur: SGS-THOMSON MICROELECTRONICS S.A., 94250 Gentilly (FR)
(72) Inventeur: Brun, Alain, 38450 Vif (FR); Lombard, Serge, 38140 Reaumont (FR)
(74) Mandataire: de Beaumont, Michel

(57) **Abrégé**

L'invention concerne la réalisation d'un échantillon de référence pour un étalonnage d'un appareil de caractérisation de doses implantées sur une plaquette (1), consistant à définir une succession d'au moins deux bandes parallèles (Bi) sur la plaquette (1), à déposer un premier masque d'implantation sur la plaquette selon un motif laissant accessible une première bande (B1), à effectuer une première implantation ionique d'une première dose, à éliminer le premier masque et à déposer un deuxième masque d'implantation sur la plaquette (1) selon un motif laissant accessible la première bande (B1) ainsi qu'une deuxième bande (B2) contiguë, à effectuer une deuxième implantation ionique d'une deuxième dose, et à éliminer le deuxième masque.

## Description

La présente invention concerne la caractérisation de doses implantées par implantation ionique sur une plaquette au moyen d'un appareil de mesure ayant recours à un laser d'excitation thermique de la plaquette. L'invention s'applique plus particulièrement à l'étalonnage de l'appareil de mesure au moyen d'échantillons de référence.

Dans un processus de fabrication de plaquettes ayant recours à une implantation et/ou à des dépôts de couches, par exemple pour la fabrication de plaquettes en micro-électronique, on effectue une caractérisation des doses implantées pour assurer qu'elles sont bien conformes à leur destination. Cette caractérisation permet, par exemple, de régler un appareil d'implantation ionique utilisée dans le processus.

Le recours à un appareil de mesure utilisant un laser d'excitation est généralement préféré à d'autres techniques antérieures (par exemple, consistant à mesurer la résistivité d'une couche implantée au moyen d'une sonde dite à "quatre pointes") car la mesure ne détériore pas la plaquette. Un appareil de mesure de ce type est connu sous la dénomination commerciale Thermaprobe de la société Thermawave.

Un tel appareil utilise deux lasers dont les faisceaux sont combinés. Un premier laser d'excitation, fonctionnant en impulsions, est destiné à chauffer localement un point de la plaquette à caractériser. Entre deux impulsions, la chaleur produite au point concerné est évacuée par des "ondes thermiques" caractéristiques de ce point et de son environnement. L'appareil analyse, entre deux impulsions, le faisceau réfléchi d'un deuxième laser de mesure continu illuminant le même point. La variation d'intensité du faisceau réfléchi est une image des ondes thermiques susmentionnées dans la mesure où le pouvoir réflecteur d'une surface dépend de sa température. Or, ces ondes thermiques sont fonction de trois paramètres de la couche implantée, à savoir, la quantité de dopant, l'énergie du bombardement ionique et le type d'impuretés qui perturbent le réseau cristallin. L'examen d'une plaquette entière s'effectue en déplaçant la plaquette dans deux directions perpendiculaires entre elles de manière à obtenir un balayage de l'ensemble de la plaquette par le faisceau laser. On obtient ainsi une caractérisation complète de la plaquette qui permet de détecter et de localiser les défauts des couches implantées.

Comme pour tout appareil de mesure, la mesure dite par "ondes thermiques" doit être étalonnée pour permettre une correction d'éventuelles dérives de fonctionnement de l'appareil.

Pour ce faire, on utilise généralement des échantillons de référence. De manière classique, on réalise plusieurs échantillons de référence au moyen de plusieurs plaquettes ayant subi des implantations ioniques de doses différentes et sous une énergie de bombardement identique. Une valeur de référence du signal délivré par l'appareil de mesure est associée à chaque plaquette. L'étalonnage de l'appareil de mesure s'effectue en introduisant successivement les plaquettes de référence dans l'appareil et en effectuant un balayage pour chaque plaquette.

Un inconvénient de la méthode classique est qu'elle nécessite de faire examiner successivement plusieurs plaquettes de référence par l'appareil de mesure pour en effectuer l'étalonnage. Plus on souhaite obtenir un étalonnage précis de l'appareil, plus le nombre d'échantillons de référence devant être examinés par l'appareil est important.

Un autre inconvénient réside dans le fait que l'étalonnage de l'appareil de mesure ne peut pas être effectué pendant que l'appareil est utilisé pour caractériser des plaquettes produites sur une ligne de fabrication. Ainsi, il est nécessaire d'arrêter le processus de fabrication des plaquettes pour pouvoir effectuer l'étalonnage de l'appareil.

La présente invention vise à pallier les inconvénients ci-dessus au moyen d'un échantillon qui permette un étalonnage de l'appareil de mesure dans toute sa plage de mesure.

L'invention vise également à permettre un étalonnage de l'appareil de mesure sans qu'il soit nécessaire d'interrompre le processus de caractérisation de plaquettes réelles sur une ligne de fabrication.

Pour atteindre ces objets, la présente invention prévoit un procédé de fabrication d'un échantillon de référence pour un étalonnage d'un appareil de caractérisation de doses implantées sur une plaquette consistant à définir une succession d'au moins deux bandes parallèles sur la plaquette ; à déposer un premier masque d'implantation sur la plaquette selon un motif laissant accessible une première bande ; à effectuer une première implantation ionique d'une première dose ; à éliminer le premier masque et à déposer un deuxième masque d'implantation sur la plaquette selon un motif laissant accessible la première bande ainsi qu'une deuxième bande contiguë ; à effectuer une deuxième implantation ionique d'une deuxième dose ; et à éliminer le deuxième masque.

Selon un mode de réalisation de la présente invention, il est prévu d'effectuer au moins un recuit à haute température de l'échantillon de référence.

Selon un mode de réalisation de la présente invention, l'échantillon de référence est caractérisé au moyen de l'appareil susmentionné pour obtenir une série d'au moins deux valeurs de référence associées à l'échantillon.

Selon un mode de réalisation de la présente invention, les implantations ioniques sont toutes réalisées avec une énergie de bombardement identique.

L'invention prévoit aussi un échantillon de référence d'un appareil de caractérisation de doses implantées sur une plaquette du type délivrant un signal en réponse à une excitation par faisceau laser de la plaquette, comportant une succession d'au moins deux bandes parallèles ayant des doses implantées différentes.

Selon un mode de réalisation de la présente invention, l'échantillon de référence comporte au moins trois bandes parallèles, et les doses de dopants diminuent d'une bande à l'autre depuis une première bande fortement implantée jusqu'à une dernière bande faiblement implantée.

L'invention prévoit aussi un appareil de caractérisation de doses implantées sur une plaquette portée par un chariot mobile dans un plan perpendiculaire à un faisceau laser, comportant, hors de la surface dans laquelle s'inscrit la plaquette, un porte-échantillon accessible par le faisceau laser lors d'un déplacement du chariot, le porte-échantillon étant destiné à recevoir au moins un échantillon de référence comportant une succession d'au moins deux bandes parallèles ayant des doses implantées différentes.

Selon un mode de réalisation de la présente invention, le porte-échantillon constitue un support d'une pastille d'ajustement automatique de la réflectivité d'un laser continu.

Un procédé d'étalonnage automatique d'un appareil de caractérisation selon l'invention consiste à placer une pastille d'un échantillon de référence sur ledit porte-échantillon ; à amener le chariot mobile dans une position où un premier laser, fonctionnant en impulsions, excite un point d'une première bande de l'échantillon ; à mesurer le pouvoir réflecteur de la surface dudit point au moyen d'un deuxième laser continu ; à déplacer le chariot dans une direction perpendiculaire aux bandes pour obtenir une valeur de mesure associée à chaque bande ; et à étalonner l'appareil en fonction de l'écart entre les valeurs mesurées et les valeurs de référence de l'échantillon.

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
les figures 1A et 1B représentent, respectivement en vue de dessus et en coupe transversale, une plaquette au cours d'une première phase d'un mode de mise en oeuvre du procédé de réalisation d'un échantillon de référence selon la présente invention ;
les figures 2A et 2B représentent, respectivement en vue de dessus et en coupe transversale, la plaquette de la figure 1 au cours d'une deuxième phase du procédé selon la présente invention ;
les figures 3A et 3B représentent, respectivement en vue de dessus et en coupe transversale, la plaquette de la figure 2 au cours d'une troisième phase du procédé selon la présente invention ;
les figures 4A et 4B représentent, respectivement en vue de dessus et en coupe transversale, un premier mode de réalisation d'un échantillon de référence selon la présente invention ;
la figure 5 représente schématiquement un appareil de mesure pourvu d'un deuxième mode de réalisation d'un échantillon de référence selon la présente invention ; et
la figure 6 représente, schématiquement et en vue de dessus, un chariot mobile d'un appareil de mesure tel que représenté à la figure 5.

Pour des raisons de clarté, les mêmes éléments ont été désignés par les mêmes références aux différentes figures. Toujours pour des raisons de clarté, les représentations des figures ne sont pas à l'échelle.

Une caractéristique de la présente invention est de permettre la réalisation d'un échantillon de référence unique auquel sont associées plusieurs valeurs d'un signal délivré par un appareil de mesure, par "ondes thermiques". permettant la caractérisation de doses implantées sur une plaquette, par exemple en silicium. Pour ce faire, l'invention prévoit d'effectuer au moins deux implantations ioniques successives sur une même plaquette de silicium.

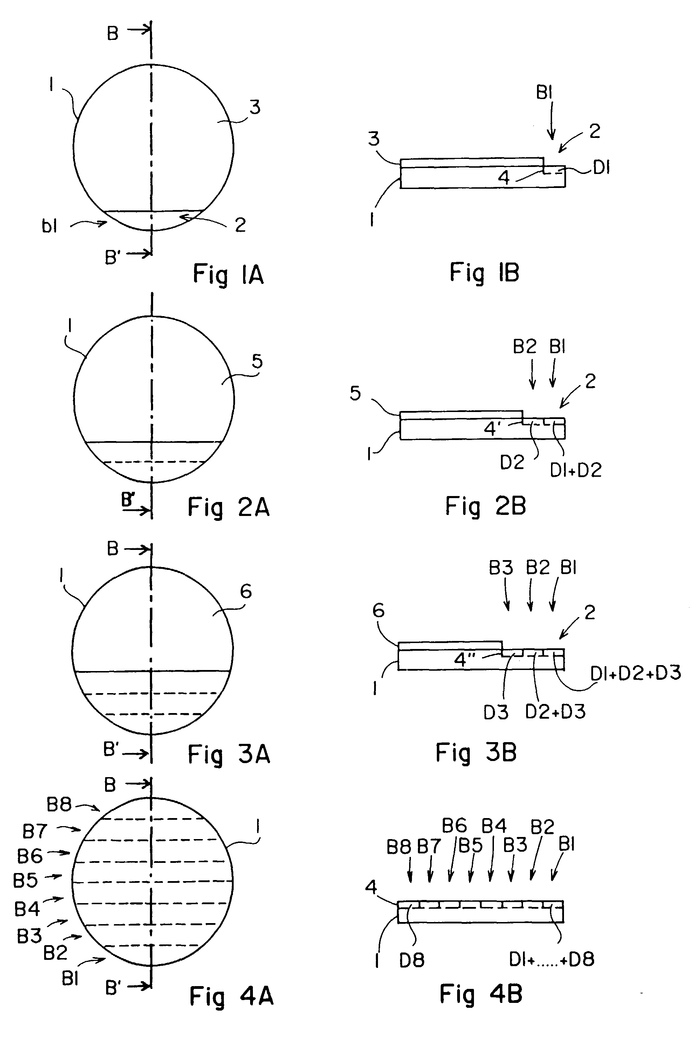

Les figures 1 à 3 illustrent trois implantations ioniques successives d'une plaquette de silicium 1 destinée à constituer un échantillon de référence selon l'invention. Les figures 1A, 2A et 3A sont des vues de dessus de la plaquette de silicium 1 et les figures 1B, 2B et 3B sont des vues en coupe transversale selon les lignes B-B' des figures respectives 1A, 2A et 3A.

Au cours d'une première phase du procédé selon l'invention (figures 1A et 1B), on commence par réaliser un masque d'implantation 3 d'une face supérieure 2 de la plaquette 1, selon un motif qui laisse accessible une première bande B1 perpendiculaire à une direction diamétrale de la plaquette 1, un bord longitudinal de la bande B1 étant défini par une portion de la périphérie de la plaquette 1. Le masque 3 est, par exemple, réalisé par photolithogravure d'une couche de résine photosensible. On réalise alors une implantation ionique de la plaquette au cours de laquelle seule la zone non-masquée, c'est-à-dire la bande B1, sera implantée. Une couche implantée 4 est donc formée au droit de la bande B1 avec une première dose D1 de dopants.

Après avoir éliminé le premier masque d'implantation 3, on réalise au cours d'une deuxième phase du procédé selon l'invention (figures 2A et 2B) un deuxième masque d'implantation 5. Le masque 5 est réalisé de la même manière que le masque 3 de la phase précédente mais selon un motif qui laisse accessible, outre la bande B1, une deuxième bande B2 parallèle et contiguë à la bande B1. On effectue alors une deuxième implantation ionique sur la plaquette 1. De préférence, cette deuxième implantation est effectuée avec la même énergie de bombardement ionique que la première implantation. On obtient alors une couche implantée 4' dont la largeur correspond à la largeur cumulée des bandes B1 et B2. La bande B2 contient une dose D2 de dopants définie par la deuxième implantation tandis que la bande B1 contient désormais une dose D1+D2 de dopants, les implantations étant cumulatives.

Après avoir éliminé le deuxième masque d'implantation 5, on effectue au cours d'une troisième phase du procédé selon l'invention une troisième implantation ionique selon un motif défini par un troisième masque 6 (figures 3A et 3B). Le motif du masque 6 est tel qu'il laisse accessible une troisième bande B3 de la surface 2 de la plaquette, la bande B3 étant parallèle aux bandes B1 et B2 et contiguë à la bande B2. La couche implantée 4" obtenue à l'issue de cette troisième phase comprend trois bandes, respectivement B1, B2 et B3, dont les doses implantées respectives sont D1+D2+D3, D2+D3 et D3.

Les figures 4A et 4B représentent, respectivement vu de dessus et en coupe transversale selon la ligne B-B' de la figure 4A, un échantillon de référence terminé. Dans cet exemple, l'échantillon comporte huit bandes B1 à B8 possédant chacune des doses implantées différentes. La bande B1 constitue la bande la plus fortement implantée, sa dose de dopants correspond au cumul des doses D1 à D8. La bande B8 est la bande la plus faiblement implantée dans la mesure où elle n'a subi que la dernière implantation avec une dose D8.

L'étalonnage de l'appareil de mesure s'effectue en plaçant l'échantillon de référence à la place d'une plaquette. On notera que l'étalonnage de l'appareil de mesure au moyen d'un échantillon de référence selon l'invention est particulièrement simple. En effet, il suffit d'effectuer un seul balayage dans la direction perpendiculaire aux bandes de l'échantillon pour connaître l'ensemble des valeurs associées à l'échantillon de référence. Les signaux représentatifs des ondes thermiques et obtenus dans les différentes bandes de l'échantillon de référence permettent un étalonnage de l'appareil de mesure.

Les doses implantées à chaque phase du procédé selon l'invention sont choisies, de préférence, pour que les doses finales de dopants contenues dans les différentes bandes correspondent à des doses d'implantation utilisées dans une ligne de fabrication à laquelle est associé l'appareil de mesure.

Le nombre de bandes de l'échantillon de référence selon l'invention est fonction du nombre de valeurs de référence à partir duquel on souhaite effectuer l'étalonnage de l'appareil de mesure. Par exemple, le nombre de bandes peut correspondre au nombre de doses d'implantations différentes utilisées dans la ligne de fabrication à laquelle est associée l'appareil de mesure.

Un avantage de la présente invention est qu'elle simplifie considérablement l'étalonnage de l'appareil de mesure. En particulier, elle permet de définir une séquence d'étalonnage automatique lorsqu'un échantillon de référence tel que représenté à la figure 4 est introduit dans l'appareil de mesure. De préférence, toutes les bandes de l'échantillon de référence possèdent la même largeur.

Pour éviter que l'échantillon de référence réalisé souffre d'instabilité, celui-ci est recuit à haute température (de l'ordre de 1000°C). En effet, en l'absence de recuit, les valeurs de référence des bandes de l'échantillon ne seraient pas stables dans le temps en raison d'une réactivation du réseau cristallin. Pour déterminer la durée du recuit nécessaire pour rendre l'échantillon stable, on pourra, par exemple, effectuer des recuits successifs de courte durée (de l'ordre de 20 secondes chacun) jusqu'à ce que le signal délivré par l'appareil de mesure soit identique après deux recuits successifs pour chaque bande de l'échantillon.

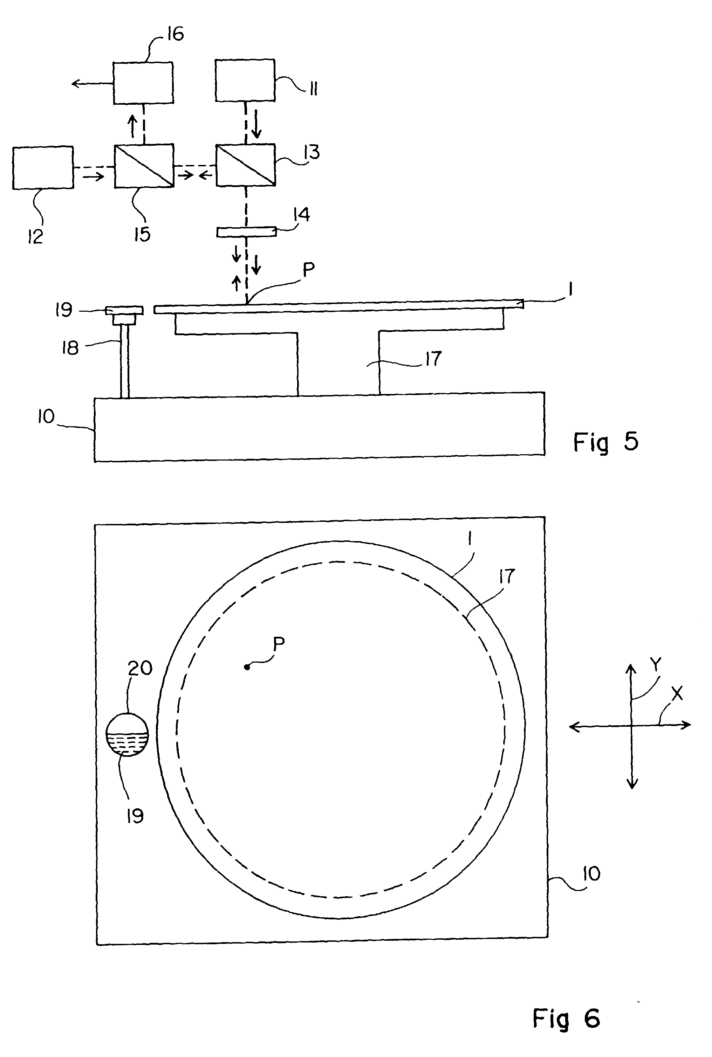

Les figures 5 et 6 illustrent un exemple d'application d'un deuxième mode de réalisation d'un échantillon de référence selon l'invention au sein d'un appareil de caractérisation de doses implantées sur des plaquettes. La figure 5 représente, partiellement et en élévation, un appareil de mesure par ondes thermiques auquel s'applique la présente invention. La figure 6 représente une vue schématique de dessus d'un chariot mobile 10 de l'appareil représenté à la figure 5. Pour des raisons de clarté, seuls les éléments nécessaires à la compréhension de l'invention ont été représentés aux figures 5 et 6.

Le fonctionnement d'un appareil de caractérisation par ondes thermiques est classique et ne sera rappelé ci-après que dans ses grandes lignes. L'appareil comporte deux lasers 11 et 12. Un premier laser 11, par exemple à argon, fonctionnant en impulsions, chauffe un point P de la surface à analyser. Entre deux impulsions, la chaleur produite au point P est évacuée par des "ondes thermiques" caractéristiques du point chauffé et de son environnement. Un deuxième laser 12, continu et de faible énergie, par exemple à hélium-néon, illumine le même point P. Son faisceau réfléchi est analysé. Dans le schéma de la figure 5, les faisceaux des lasers 11 et 12 sont mélangés par un combinateur 13 et concentrés par une lentille focalisatrice 14 pour éclairer le point P. Le faisceau réfléchi du laser 12 est renvoyé par le combinateur 13 et une séparatrice 15 vers un détecteur 16 qui fournit donc une image du signal d'ondes thermiques.

Le signal d'ondes thermiques permet, notamment, de détecter localement des inhomogénéités de doses implantées, des impuretés autres que le ou les dopants souhaités ou des ruptures de réseau cristallin.

On notera que le signal d'ondes thermiques est indépendant de la nature de l'espèce implantée. Ainsi, l'étalonnage de l'appareil de mesure au moyen de l'échantillon de référence selon la présente invention est indépendant de l'espèce implantée dans cet échantillon.

L'appareil de mesure comporte un chariot mobile 10 sur lequel est monté un support de plaquette 17 destiné à recevoir une plaquette 1 devant être caractérisée. Le chariot 10 est mobile dans deux directions perpendiculaires (symbolisées par les flèches X et Y à la figure 6) de manière à permettre un balayage de la surface de la plaquette 1 par le faisceau laser.

Selon l'invention, le chariot 10 supporte également un porte-échantillon 18 destiné à recevoir au moins un échantillon de référence 19 réalisé conformément au deuxième mode de réalisation de la présente invention. Le porte-échantillon 18 est disposé hors de la surface dans laquelle s'inscrit une plaquette 1 devant être caractérisée. L'échantillon 19 est de taille réduite par rapport à la taille d'une plaquette 1. L'échantillon 19 peut être obtenu en découpant une pastille de faible diamètre (par exemple de l'ordre de 10x10 mm) dans une plaquette de silicium à laquelle on a fait subir le procédé exposé en relation avec les figures 1 à 4. Dans ce cas, la largeur des bandes définies dans la plaquette servant à réaliser l'échantillon est adaptée pour que l'intégralité de la plage de doses implantées souhaitée soit contenue dans la pastille découpée.

Un avantage de ce mode de réalisation est qu'il permet que l'échantillon de référence soit en permanence présent dans l'appareil de mesure pendant la caractérisation de plaquettes à examiner. Ainsi, il est possible d'effectuer un étalonnage de l'appareil de mesure sans interrompre la caractérisation des plaquettes fabriquées sur la ligne de fabrication à laquelle est associé l'appareil de mesure. On prévoit, par exemple, un étalonnage périodique de l'appareil de mesure entre chaque plaquette ou entre deux lots de plaquettes.

De préférence et comme le montre la figure 6, la pastille 19 est associée à une pastille 20, généralement en platine, dont est pourvu l'appareil de mesure pour étalonner la réflectivité du laser 12. On tire ainsi profit de l'existence d'une zone du chariot mobile 10 dont le balayage est déjà prévu par le dispositif de commande (non représenté) de l'appareil de mesure, ce qui simplifie la programmation de ce dispositif de commande pour effectuer l'étalonnage selon la présente invention.

Les adaptations du dispositif de commande, généralement programmables, de l'appareil de mesure sont à la portée de l'homme du métier.

Bien entendu, la présente invention est susceptible de diverses variantes et modifications qui apparaîtront à l'homme de l'art. En particulier, le nombre de bandes de l'échantillon de référence, que ce soit selon le premier ou le deuxième mode de réalisation exposé ci-dessus pourra être modifié en fonction de l'étalonnage de l'appareil de mesure que l'on souhaite effectuer. De plus, on notera qu'un échantillon selon l'invention peut également être réalisé par implantations ioniques successives de doses définies pour chaque bande individuellement. Dans ce cas, chaque bande est implantée une seule fois et les masques d'implantation sont adaptés en conséquence.

## Revendications

1. Procédé de fabrication d'un échantillon de référence (19) pour un étalonnage d'un appareil de caractérisation de doses implantées sur une plaquette (1), caractérisé en ce qu'il consiste :
- à définir une succession d'au moins deux bandes parallèles (Bi) sur la plaquette (1) ;
- à déposer un premier masque d'implantation (3) sur la plaquette (1) selon un motif laissant accessible une première bande (B1) ;
- à effectuer une première implantation ionique d'une première dose (D1) ;
- à éliminer le premier masque (3) et à déposer un deuxième masque d'implantation (5) sur la plaquette (1) selon un motif laissant accessible la première bande (B1) ainsi qu'une deuxième bande (B2) contiguë ;
- à effectuer une deuxième implantation ionique d'une deuxième dose (D2) ; et
- à éliminer le deuxième masque (5).

2. Procédé de fabrication d'un échantillon de référence selon la revendication 1, caractérisé en ce qu'il consiste à effectuer au moins un recuit à haute température de l'échantillon de référence (19).

3. Procédé de fabrication d'un échantillon de référence selon la revendication 1 ou 2, caractérisé en ce qu'il consiste à caractériser l'échantillon de référence (19) au moyen dudit appareil pour obtenir une série d'au moins deux valeurs de référence associées à l'échantillon.

4. Procédé de fabrication d'un échantillon de référence selon l'une quelconque des revendications 1 à 3, caractérisé en ce que lesdites implantations ioniques sont toutes réalisées avec une énergie de bombardement identique.

5. Échantillon de référence (19) d'un appareil de caractérisation de doses implantées sur une plaquette (1) du type délivrant un signal en réponse à une excitation par faisceau laser de la plaquette (1), caractérisé en ce qu'il comporte une succession d'au moins deux bandes (Bi) parallèles ayant des doses implantées (Di) différentes.

6. Échantillon de référence selon la revendication 5, caractérisé en ce qu'il comporte au moins trois bandes parallèles (B1, B2, B3), et en ce que les doses de dopants (D1+D2+D3, D2+D3, D3) diminuent d'une bande à l'autre depuis une première bande (B1) fortement implantée jusqu'à une dernière bande faiblement implantée.

7. Appareil de caractérisation de doses implantées sur une plaquette (1) portée par un chariot (10) mobile dans un plan perpendiculaire à un faisceau laser, caractérisé en ce qu'il comporte, hors de la surface dans laquelle s'inscrit ladite plaquette (1), un porte-échantillon (18) accessible par le faisceau laser lors d'un déplacement du chariot (10), ledit porte-échantillon (18) étant destiné à recevoir au moins un échantillon de référence (19) comportant une succession d'au moins deux bandes parallèles (Bi) ayant des doses implantées (Di) différentes.

8. Appareil selon la revendication 7, caractérisé en ce que ledit porte-échantillon (18) constitue un support d'une pastille (20) d'ajustement automatique de la réflectivité d'un laser continu (12).

9. Procédé d'étalonnage automatique d'un appareil de caractérisation selon la revendication 7 ou 8, caractérisé en ce qu'il consiste :
- à placer une pastille d'un échantillon de référence (19) sur ledit porte-échantillon (18) ;
- à amener le chariot mobile (10) dans une position où un premier laser (11), fonctionnant en impulsions, excite un point d'une première bande (B1) de l'échantillon (19) ;
- à mesurer le pouvoir réflecteur de la surface dudit point au moyen d'un deuxième laser continu (12) ;
- à déplacer le chariot (10) dans une direction (Y) perpendiculaire aux bandes (Bi) pour obtenir une valeur de mesure associée à chaque bande (Bi) ; et
- à étalonner l'appareil en fonction de l'écart entre les valeurs mesurées et les valeurs de référence de l'échantillon (19).
